# EUROPEAN PATENT SPECIFICATION

(11) **EP 2 105 712 B1**
(45) Date of publication and mention of the grant of the patent: **27.04.2016**
(21) Application number: 06843595.7
(22) Date of filing: 28.12.2006
(51) Int. Cl.: G01B 7/00, G01D 5/14, B66B 3/00, F01N 3/00, G01B 7/24

(54) **MAGNETIC POSITION SENSOR**
MAGNETPOSITIONSSENSOR
DETECTEUR DE POSITION MAGNETIQUE

(43) Date of publication of application: 30.09.2009
(73) Proprietor: Mitsubishi Electric Corporation, Chiyoda-ku Tokyo 100-8310 (JP)
(72) Inventor: NISHIURA, Ryuichi, Tokyo 100-8310 (JP); NISHIZAWA, Hiroshi, Tokyo 100-8310 (JP); UEDA, Takaharu, Tokyo 100-8310 (JP)
(74) Representative: Hoffmann Eitle
(86) International application number: PCT/JP2006/326217
(87) International publication number: WO 2008/081533

(56) References cited:
- EP-A1- 1 211 476
- JP-A- 2001 197 715
- JP-A- 2003 139 560
- JP-A- 2004 177 398
- US-A- 5 781 006

## Description

### TECHNICAL FIELD

The present invention relates to a magnetic position sensor that detects position of a measured object using a magnetic detecting element.

### BACKGROUND ART

Conventional magnetic position sensors have: a pair of first ferromagnetic stators that are disposed parallel to each other on opposite sides of an auxiliary air gap; and a second ferromagnetic stator that faces the first ferromagnetic stators across a main air gap. A permanent magnet that is magnetized so as to have two poles is disposed in the main air gap. The permanent magnet generates two magnetic flux loops that have a branch point at a center thereof, and is displaceable along the main air gap. A magnetic detecting element is disposed in the magnet auxiliary air gap. Positions of the magnetic flux loops change when the permanent magnet is displaced inside the main air gap due to displacement of the measured object, and this is detected by the magnetic detecting element (see Patent Literature 1, for example).

### Patent Literature 1

Japanese Patent No. 3264929 (Gazette)
EP 1 211 476 A1 relates to a non-contact position sensor. A device comprises a first stator, a second stator, and a hall element provided between the first and second stators. Two magnets are located next to each other along the direction of a locus linking two magnet facing sides of the first stator. When the movable magnets are exactly at the center, a magnetic circuit A is formed by the moveable magnets and the first stator, and a magnetic circuit B is formed by the moveable magnets and the second stator. Further, when the moveable magnets come e.g. to the right end, only a single magnetic circuit C is formed by the moveable magnets and the right hand side of the first and second stators.

### DISCLOSURE OF THE INVENTION

### PROBLEM TO BE SOLVED BY THE INVENTION

In conventional magnetic position sensors such as that described above, since the branch point of the magnetic flux loops is always at the center of the permanent magnet, it is necessary to make a stroke uniform in two directions relative to the origin position. For this reason, accuracy of measurement is reduced if the origin position is not aligned centrally throughout the stroke (i.e., if it is inclined).

The present invention aims to solve the above problems and an object of the present invention is to provide a magnetic position sensor that enables decreases in accuracy of measurement to be suppressed by enabling an origin position to be adjusted so as to correspond to a place of use.

### MEANS FOR SOLVING THE PROBLEM

A magnetic position sensor includes: first and second detecting cores that are disposed so as to line up with each other on opposite sides of a detecting gap; a magnet unit having: first and second magnet cores that are disposed so as to line up with each other on opposite sides of an origin gap; and a magnet that generates two magnetic flux loops between the first and second detecting cores and the first and second magnet cores, the magnetic flux loops having a boundary at the origin gap, the magnet unit being displaced relative to the first and second detecting cores together with displacement of a measured object; and a magnetic detecting element that is disposed in the detecting gap, and that detects magnetic flux that passes through the detecting gap.

### BRIEF DESCRIPTION OF THE DRAWINGS

Figure 1 is a cross section of a magnetic position sensor according to Embodiment 1 of the present invention;
Figure 2 is a front elevation that shows a magnetic detecting element from Figure 1;
Figure 3 is an explanatory diagram that shows an example of magnetic flux loops that are generated by the magnetic position sensor in Figure 1;
Figure 4 is an explanatory diagram that shows an example of magnetic flux loops when a movable body from Figure 3 has been displaced;
Figure 5 is an explanatory diagram that shows a magnetic flux loop when there is no overlap between an end portion of a magnet and a first fixed core at a maximum stroke position;
Figure 6 is an explanatory diagram that shows a magnetic flux loop when a second movable core projects further outward than an end surface of a second fixed core at a maximum stroke position;
Figure 7 is a structural diagram that shows an example in which the magnetic position sensor in Figure 1 is applied to an elevator weighing apparatus;
Figure 8 is a structural diagram that shows portion VIII in Figure 7 enlarged;
Figure 9 is a structural diagram that shows an example in which the magnetic position sensor in Figure 1 is applied to an opening measuring apparatus of an automotive exhaust gas recirculation valve;
Figure 10 is a structural diagram that shows part of a magnetic position sensor according to Embodiment 2 of the present invention;
Figure 11 is a structural diagram that shows part of a magnetic position sensor according to Embodiment 3 of the present invention;
Figure 12 is a structural diagram that shows part of a magnetic position sensor according to Embodiment 4 of the present invention;
Figure 13 is a structural diagram that shows part of a magnetic position sensor according to Embodiment 5 of the present invention;
Figure 14 is an explanatory diagram that shows a magnetic flux loop at a maximum stroke position when magnet end gaps from Figure 13 are not disposed;
Figure 15 is an explanatory diagram that shows the magnetic flux loop at the maximum stroke position when the magnet end gaps from Figure 13 are disposed;
Figure 16 is an exploded perspective that shows an example of a configuration for installing first and second movable cores and a magnet from Figure 13 into a holding part;
Figure 17 is a structural diagram that shows part of a magnetic position sensor according to Embodiment 6 of the present invention;
Figure 18 is a structural diagram that shows part of a magnetic position sensor according to Embodiment 7 of the present invention;
Figure 19 is a structural diagram that shows a state in which first and second movable cores and a magnet are inclined relative to first and second fixed cores from Figure 18;
Figure 20 is a structural diagram that shows part of a magnetic position sensor according to Embodiment 8 of the present invention;
Figure 21 is a cross section of a magnetic position sensor according to Embodiment 9 of the present invention;
Figure 22 is a cross section taken along line XXII - XXII in Figure 21;
Figure 23 is a perspective that shows a fixed core from Figure 21;
Figure 24 is a perspective that shows a movable core from Figure 21;
Figure 25 is an explanatory diagram that shows relationships among first and second fixed cores and magnetic detecting elements of a magnetic position sensor according to Embodiment 10 of the present invention;
Figure 26 is a perspective that shows movable cores of a magnetic position sensor according to Embodiment 11 of the present invention;
Figure 27 is a structural diagram that shows part of a magnetic position sensor according to Embodiment 12 of the present invention;
Figure 28 is a cross section taken along line XXVIII - XXVIII in Figure 27;
Figure 29 is a structural diagram that shows part of a magnetic position sensor according to Embodiment 13 of the present invention;
Figure 30 is a cross section taken along line XXX - XXX in Figure 29;
Figure 31 is a cross section taken along line XXXI - XXXI in Figure 29;
Figure 32 is a partial cross section of a magnetic position sensor according to Embodiment 14 of the present invention;
Figure 33 is an exploded perspective that shows part of a magnetic position sensor according to Embodiment 15 of the present invention;
Figure 34 is a partial cross section of the magnetic position sensor in Figure 33;
Figure 35 is a partial cross section of a magnetic position sensor according to Embodiment 16 of the present invention;
Figure 36 is a partial cross section of a magnetic position sensor according to Embodiment 17 of the present invention;
Figure 37 is a structural diagram that shows part of a magnetic position sensor according to Embodiment 18 of the present invention;
Figure 38 is a cross section taken along line XXXVIII - XXXVIII in Figure 37;
Figure 39 is a structural diagram that shows part of a magnetic position sensor according to Embodiment 19 of the present invention;
Figure 40 is a cross section taken along line XXXX - XXXX in Figure 39;
Figure 41 is a perspective that shows a fixed core from Figure 39;
Figure 42 is a partial cross section of a magnetic position sensor according to Embodiment 20 of the present invention;
Figure 43 is a partial cross section of a magnetic position sensor according to Embodiment 21 of the present invention;
Figure 44 is a partial cross section of a magnetic position sensor according to Embodiment 22 of the present invention;
Figure 45 is a front elevation that shows a movable core from Figure 44; and
Figure 46 is a partial cross section of a magnetic position sensor according to Embodiment 23 of the present invention.

### BEST MODE FOR CARRYING OUT THE INVENTION

Preferred embodiments of the present invention will now be explained with reference to the drawings.

### Embodiment 1

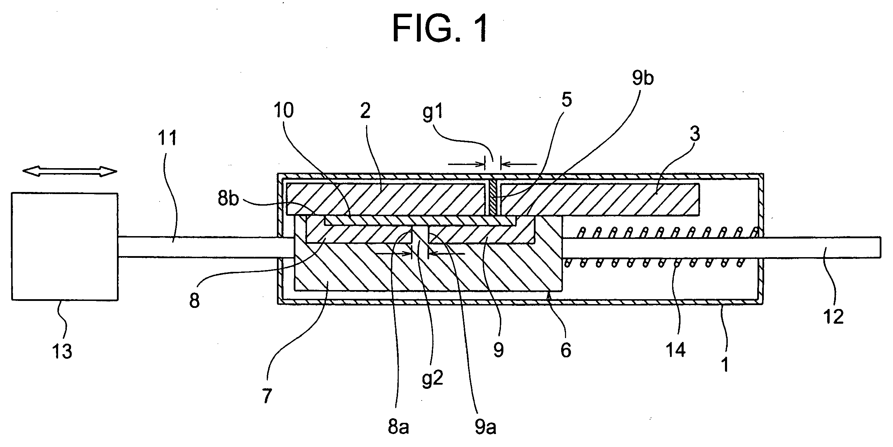

Figure 1 is a cross section of a magnetic position sensor according to Embodiment 1 of the present invention. In the figure, flat first and second fixed cores (detecting cores) 2 and 3 that are constituted by a ferromagnetic material such as iron, etc., for example, are fixed inside a housing 1. The fixed cores 2 and 3 are disposed so as to line up in a straight line on opposite sides of a detecting gap g1. A magnetic detecting element 5 is disposed in the detecting gap g1.

A movable body (a magnet unit) 6 that is displaceable by sliding along the fixed cores 2 and 3 in a direction that is perpendicular to the detecting gap g1 (left-to-right in the figure) is disposed inside a housing 1. The movable body 6 has: a holding part 7; first and second movable cores (magnet cores) 8 and 9 that are constituted by a ferromagnetic material such as iron, etc., for example; and a flat magnet (a permanent magnet) 10.

The movable cores 8 and 9 are held by the holding part 7. The movable cores 8 and 9 have L-shaped cross sections, and are disposed so as to have opposite orientations from each other. In addition, the movable cores 8 and 9 have: origin gap surfaces 8a and 9a that face each other on opposite sides of an origin gap g2; and fixed-core-facing surfaces 8b and 9b that face and contact the fixed cores 2 and 3.

The magnet 10 is held between the fixed cores 2 and 3 and the movable cores 8 and 9. The magnet 10 is magnetized so as to have two poles, and has a direction of magnetization that is vertical in the figure.

First and second shafts 11 and 12 that are made of a nonmagnetic material are fixed to two end portions of the movable body 6 in a direction of movement. A measured object 13 is placed in contact with the first shaft 11. The second shaft 12 is inserted through a spring 14. The spring 14 is disposed between the housing 1 and the movable body 6, and forces the movable body 6 and the first shaft 11 toward the measured object 13.

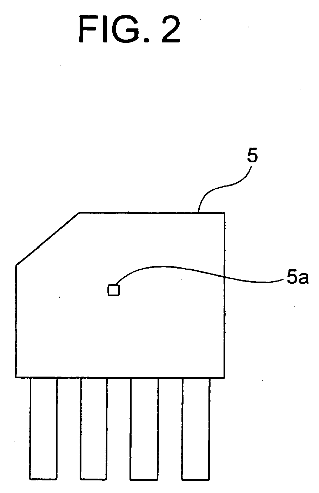

Figure 2 is a front elevation that shows the magnetic detecting element 5 from Figure 1. A magnetic sensor that has sensitivity only on a single axis, such as a Hall integrated circuit, etc., can be used for the magnetic detecting element 5, for example. A magnetically sensitive portion 5a that is constituted by a Hall element, for example, is disposed on the magnetic detecting element 5. The magnetic detecting element 5 has a direction of magnetic sensitivity that is left-to-right in Figure 1, in other words, a direction that is parallel to the direction of movement of the movable body 6.

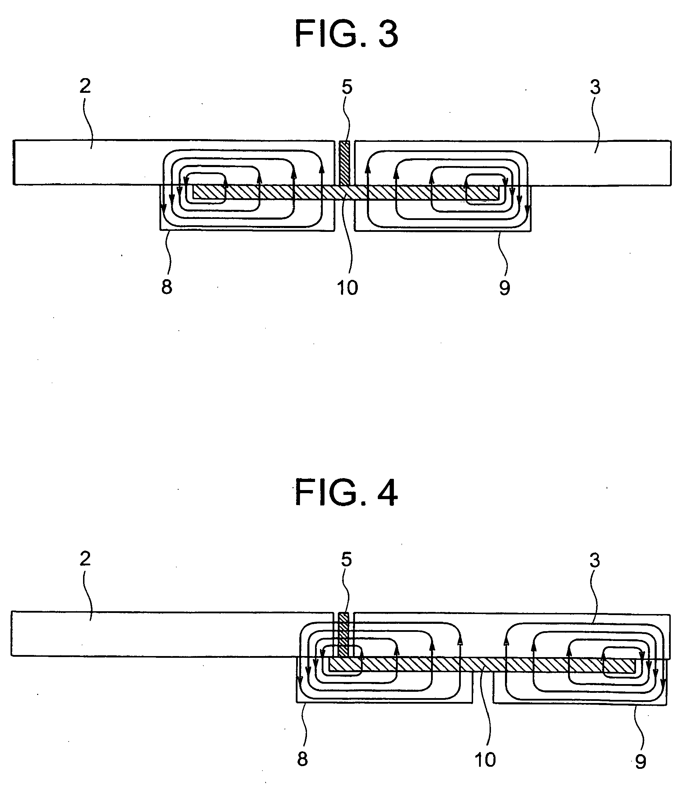

Figure 3 is an explanatory diagram that shows an example of magnetic flux loops that are generated by the magnetic position sensor in Figure 1, and Figure 4 is an explanatory diagram that shows an example of magnetic flux loops when the movable body 6 from Figure 3 has been displaced. In a magnetic position sensor such as that described above, two magnetic flux loops are generated that have a boundary at the origin gap g2. The movable cores 8 and 9 and the magnet 10 are integrated, and when these move left or right in the figures, the magnetic flux loops also move left or right. Here, since the magnetic flux that passes through the magnetic detecting element 5 changes in proportion to the position of the movable body 6, the position of the measured object 13 can be detected based on the magnetic flux that the magnetic detecting element 5 detects.

For example, Figure 4 shows the magnetic flux loops at a maximum stroke position. When a branch point of the magnetic flux loops (the origin gap g2) is aligned with the position of the magnetic detecting element 5, for example, as shown in Figure 3, the magnetic flux that passes through the magnetic detecting element 5 is only in a vertical direction in the figure, and no magnetic flux will be detected by the magnetic detecting element 5, which has uniaxial sensitivity.

Now, since errors (absolute values) generated by the magnetic detecting element 5 increase in proportion to the output from the magnetic detecting element 5, decreases in accuracy of measurement can be suppressed by adjusting the origin (zero point) of the magnetic detecting element 5 so as to coincide with the portion for which measurement is most desired. For example, if the origin of the magnetic detecting element 5 is misaligned from the position of the measured object by 5 mm, the absolute quantity of the error will be doubled if a 5-mm measurement of position is performed since this corresponds to a position that is 10 mm from the origin of the magnetic detecting element 5.

Using a magnetic position sensor such as that described above, it is possible to adjust the position of the branch point of the magnetic flux loops by means of the position of the origin gap g2, enabling the origin position to be adjusted so as to correspond to the place of use, thereby enabling decreases in accuracy of measurement to be suppressed.

In Embodiment 1, as shown in Figure 4, the magnet 10 overlaps with the first and second fixed cores 2 and 3 even if the movable body 6 is moved to the maximum stroke position that enables position detection. For example, the end portion of the magnet 10 overlaps with the first fixed core 2. Because of this, the magnetic flux that passes through the detecting gap g1 can be kept parallel to the direction of magnetic sensitivity of the magnetic detecting element 5 even at the maximum stroke position. Thus, linearity of sensor output can be improved in a vicinity of the maximum stroke position.

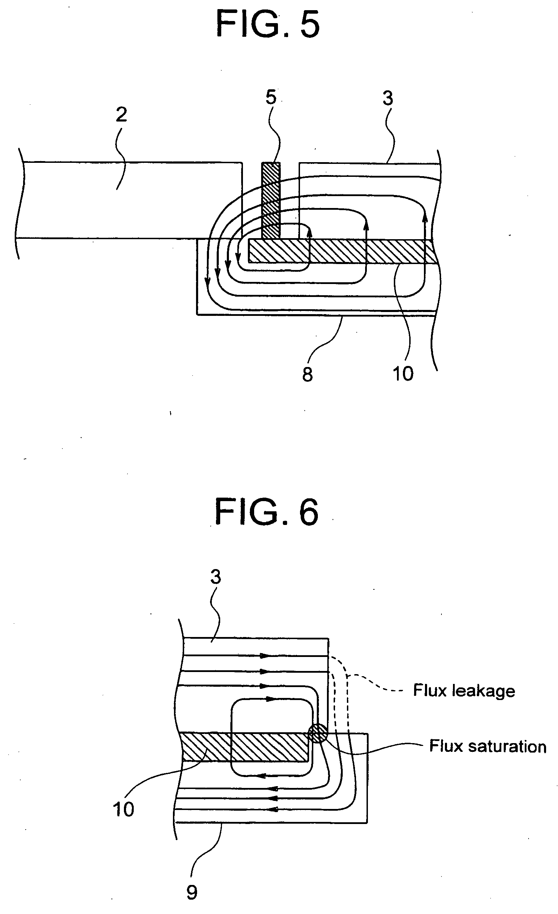

In contrast to this, if the end portion of the magnet 10 does not overlap with the first fixed core 2 at the maximum stroke position, as shown in Figure 5, the magnetic flux that passes through the detecting gap g1 will be inclined relative to the direction of magnetic sensitivity of the magnetic detecting element 5. Thus, linearity of the sensor output in the vicinity of the maximum stroke position will be reduced.

In addition, in Embodiment 1, the first and second movable cores 8 and 9 are positioned within limits of the first and second fixed cores 2 and 3 even if the movable body 6 is moved to the position of the maximum stroke that enables position detection, as shown in Figure 4. For example, the second movable core 9 does not project beyond the end surface of the second fixed core 3. Because of this, the occurrence of magnetic flux leakage can be prevented even at the maximum stroke position, enabling decreases in accuracy of measurement to be prevented.

In contrast to this, if the second movable core 9 projects beyond the end surface of the second fixed core 3 at the maximum stroke position, as shown in Figure 6, magnetic flux saturation may arise in portions of the magnetic path, and magnetic flux leakage will be generated.

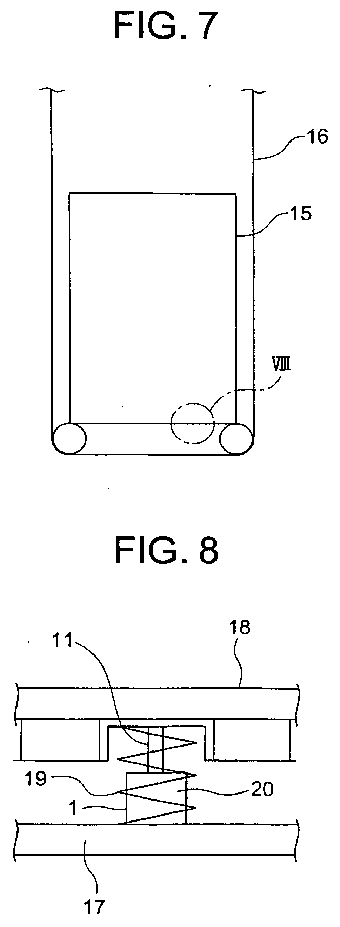

Figure 7 is a structural diagram that shows an example in which the magnetic position sensor in Figure 1 is applied to an elevator weighing apparatus, and Figure 8 is a structural diagram that shows portion VIII in Figure 7 enlarged. In the figures, a car 15 that accommodates passengers is suspended inside a hoistway by a main rope 16, and is raised and lowered by a driving force from a hoisting machine (not shown). The car 15 has: a car frame 17; and a cage 18 that is supported by the car frame 17.

A spring (an elastic body) 19 that expands and contracts in response to load weight inside the cage 18 and a magnetic position sensor 20 that functions as a weighing apparatus that detects displacement of the floor portion of the cage 18 are disposed between a floor portion of the cage 18 and a lower beam of the car frame 17. Basic principles of the magnetic position sensor 20 are similar to those in Figure 1, and the cage 18 corresponds to the measured object 13. Signals that correspond to positions of the floor portion of the cage 18, i.e., signals that correspond to load weights, are obtained from the magnetic position sensor 20. Consequently, the magnetic position sensor 20 can be used as a weighing apparatus.

Moreover, the weighing apparatus can also be disposed at another location on the elevator such a rope shackle or a rope fastening portion, for example.

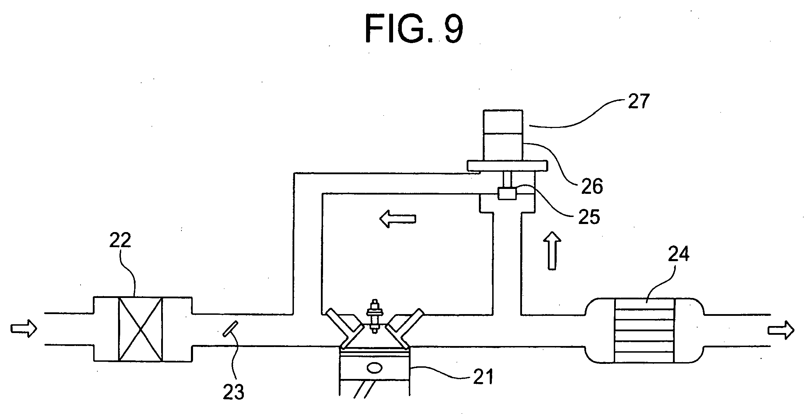

Next, Figure 9 is a structural diagram that shows an example in which the magnetic position sensor in Figure 1 is applied to an opening measuring apparatus of an automotive exhaust gas recirculation valve. In the figure, air is supplied to an engine 21 by means of an air cleaner 22 and a throttle valve 23. Exhaust gas from the engine 21 is discharged externally through a catalyst 24. A portion of the exhaust gas is resupplied to the engine 21 by means of an exhaust gas recirculation valve 25.

The exhaust gas recirculation valve 25 is opened and closed by an actuator 26. A magnetic position sensor 27 is disposed on the actuator 26 so as to function as an opening measuring apparatus for measuring the degree of opening of the exhaust gas recirculation valve 25. Basic principles of the magnetic position sensor 27 are similar to those in Figure 1, and the exhaust gas recirculation valve 25 or the drive shaft of the actuator 26 correspond to the measured object 13. Signals that correspond to the degree of opening of the exhaust gas recirculation valve 25 are obtained from the magnetic position sensor 27. Consequently, the magnetic position sensor 27 can be used as an opening measuring apparatus.

Thus, a magnetic position sensor according to the present invention can be used for any application, and the origin position can be adjusted so as to correspond to the place of use, enabling decreases in accuracy of measurement to be suppressed.

### Embodiment 2

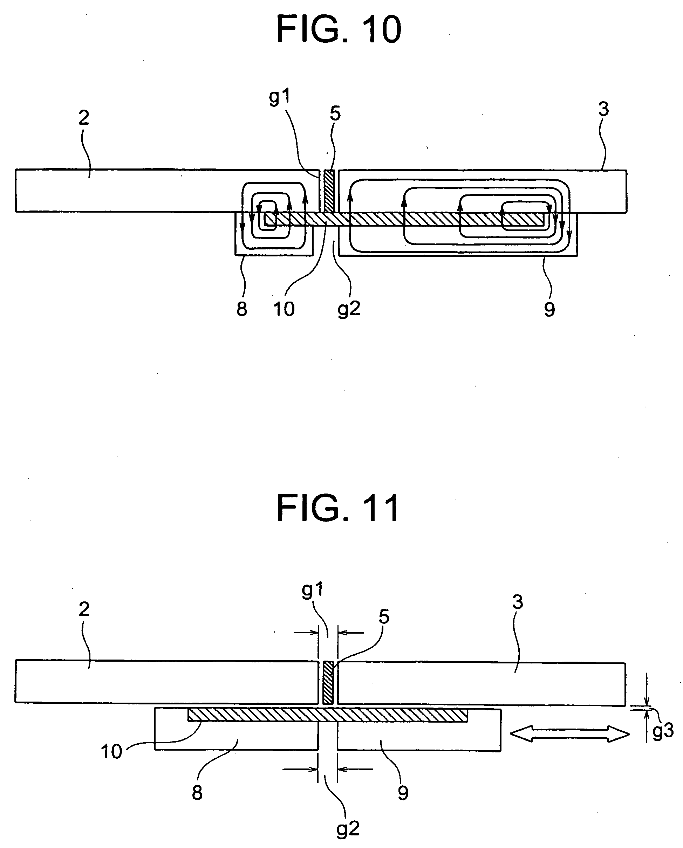

Next, Figure 10 is a structural diagram that shows part of a magnetic position sensor according to Embodiment 2 of the present invention. In this example, a longitudinal dimension of a first movable core 8 is shorter than a longitudinal dimension of a second movable core 9. Thus, strokes becomes non-symmetrical on two sides of an origin. The rest of the configuration is similar to that of Embodiment 1.

The strokes may thereby be made asymmetric, and the origin position can be adjusted so as to correspond to the place of use, enabling decreases in accuracy of measurement to be suppressed.

### Embodiment 3

Next, Figure 11 is a structural diagram that shows part of a magnetic position sensor according to Embodiment 3 of the present invention. In this example, a fluctuation control gap g3 is disposed between fixed cores 2 and 3 and movable cores 8 and 9 and between the fixed cores 2 and 3 and a magnet 10. In other words, a movable body 6 (see Figure 1) faces the fixed cores 2 and 3 across a space. Consequently, a guide member (not shown) is used to guide displacement of the movable body 6. The rest of the configuration is similar to that of Embodiment 1.

In a magnetic position sensor of this kind, resistance to gap fluctuations due to displacement of the movable cores 8 and 9 and the magnet 10 in a direction toward or away from the fixed cores 2 and 3 (vertically in the figure) is increased by the fluctuation control gap g3.

For example, if the movable cores 8 and 9 and the magnet 10 are placed in contact with the fixed cores 2 and 3 initially, fluctuations in overall magnetic resistance may be increased severalfold if a gap of even 0.1 mm arises between the two since air has a magnetic resistance that is as much as three orders of magnitude higher than that of a ferromagnetic material. In contrast to that, when a fluctuation control gap g3 is present in advance, even if the fluctuation control gap g3 fluctuates by 0.1 mm from 1.0 mm, for example, the rate of change in overall magnetic resistance is suppressed to approximately 10 percent.

Now, since a magnetic detecting element 5 generates signals that correspond to the magnetic flux that passes through the detecting gap g1, the effects of changes in magnetic resistance that are mentioned above are not small. Consequently, stable output can be obtained relative to displacement of the movable cores 8 and 9 and the magnet 10 in the direction toward or away from the fixed cores 2 and 3 by predisposing the fluctuation control gap g3.

Magnetic flux density can also be adjusted so as to be appropriate to the sensitivity of the magnetic detecting element 5 by adjusting the size of the fluctuation control gap g3.

### Embodiment 4

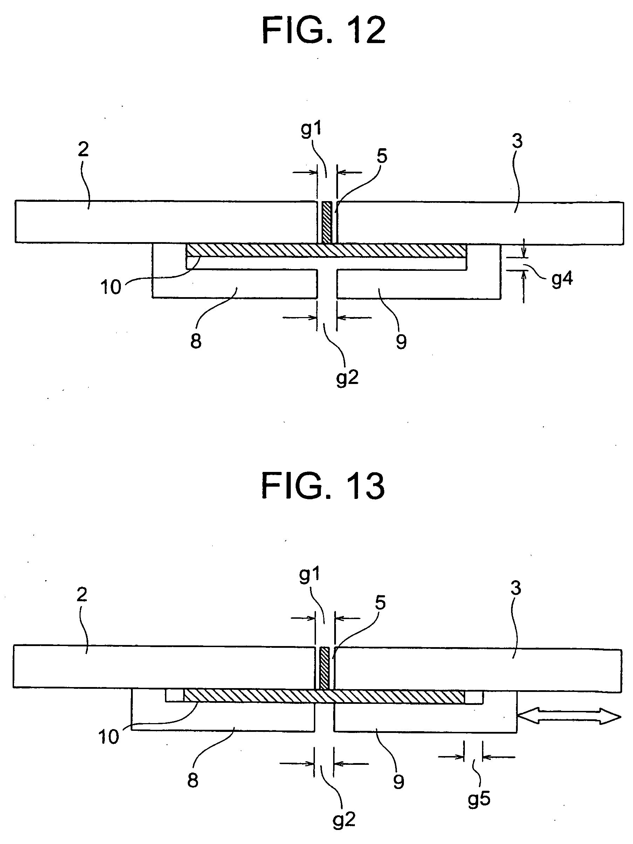

Next, Figure 12 is a structural diagram that shows part of a magnetic position sensor according to Embodiment 4 of the present invention. In this example, a fluctuation control gap g4 is disposed between a magnetic pole face of a magnet 10 near movable cores 8 and 9 and the movable cores 8 and 9. The rest of the configuration is similar to that of Embodiment 1.

In a magnetic position sensor of this kind, since a magnetic gap is also disposed in portions of the magnetic flux loops in advance, stable output can be obtained relative to displacement of the movable cores 8 and 9 and the magnet 10 in the direction toward or away from the fixed cores 2 and 3 in a similar manner to Embodiment 3.

### Embodiment 5

Next, Figure 13 is a structural diagram that shows part of a magnetic position sensor according to Embodiment 5 of the present invention. In this example, magnet end gaps g5 are disposed between two end surfaces of a magnet 10 in a direction of movement and movable cores 8 and 9. The rest of the configuration is similar to that of Embodiment 1.

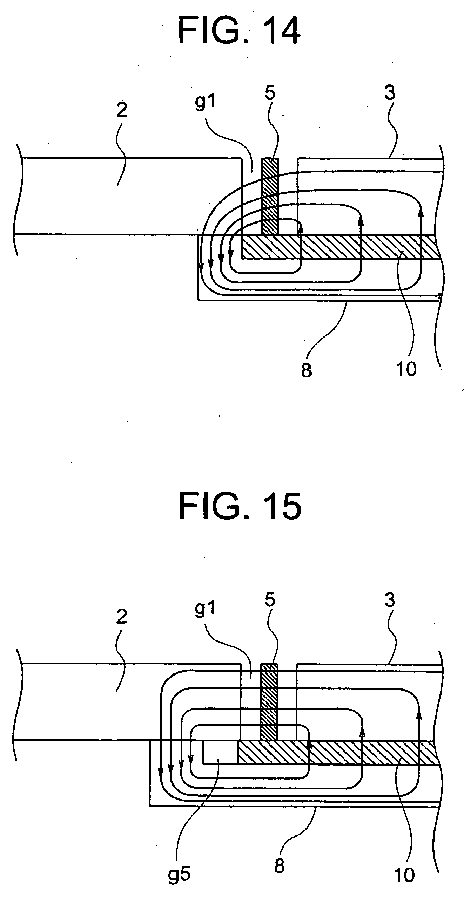

Now, Figure 14 is an explanatory diagram that shows a magnetic flux loop at a maximum stroke position when magnet end gaps g5 from Figure 13 are not disposed, and Figure 15 is an explanatory diagram that shows the magnetic flux loop at the maximum stroke position when the magnet end gaps g5 from Figure 13 are disposed.

When magnet end gaps g5 are not disposed, the magnetic flux that passes through the detecting gap g1 at the maximum stroke position is inclined relative to the direction of magnetic sensitivity of the magnetic detecting element 5. Thus, linearity of the sensor output in the vicinity of the maximum stroke position decreases. In contrast to that, when the magnet end gaps g5 are disposed, the magnetic flux that passes through the detecting gap g1 can be kept parallel to the direction of magnetic sensitivity of the magnetic detecting element 5 even at the maximum stroke position. Thus, linearity of sensor output can be improved in a vicinity of the maximum stroke position.

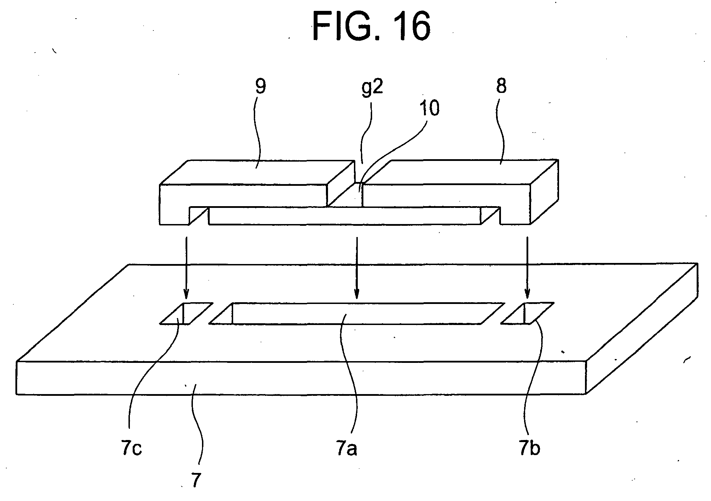

Figure 16 is an exploded perspective that shows an example of a configuration for installing the first and second movable cores 8 and 9 and the magnet 10 from Figure 13 into a holding part 7. A magnet insertion aperture 7a into which the magnet 10 is inserted and core insertion apertures 7b and 7c into which end portions of the movable cores 8 and 9 are inserted are disposed on the holding part 7. Since the two end portions of the magnet 10 do not affect the size of the magnetic flux density very much due to the disposition of the magnet end gaps g5, the movable cores 8 and 9 and the magnet 10 can be integrated easily by inserting the holding part 7 into the magnet end gaps g5.

### Embodiment 6

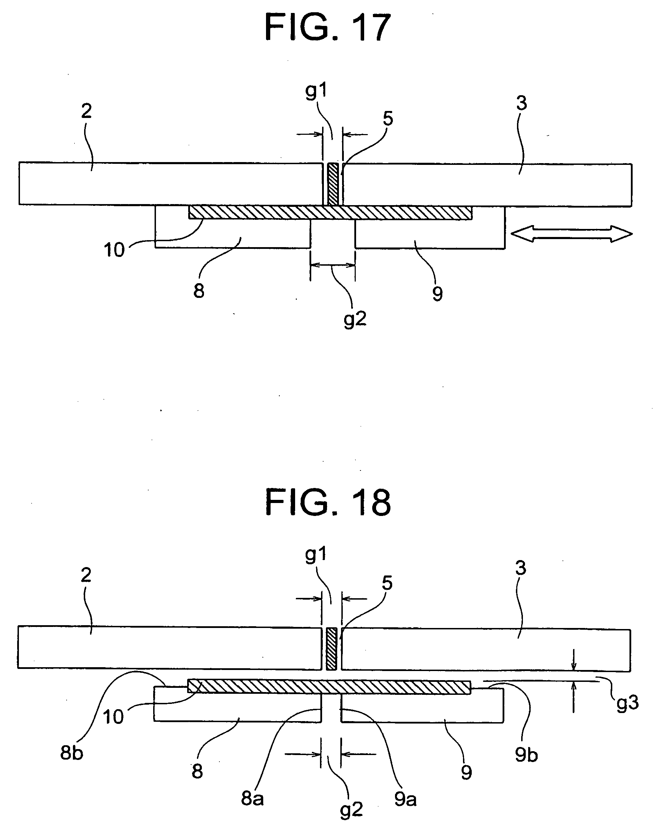

Next, Figure 17 is a structural diagram that shows part of a magnetic position sensor according to Embodiment 6 of the present invention. In this example, a dimension of an origin gap g2 in a direction of movement of movable cores 8 and 9 and a magnet 10 is greater than a dimension of a detecting gap g1 in the same direction (g2 > g1). The rest of the configuration is similar to that of Embodiment 1.

In a magnetic position sensor of this kind, since the origin gap g2 is a wider than the detecting gap g1, magnetic resistance is greater in the origin gap g2, enabling branching of the magnetic flux loops to be made clear, and also enabling setting of the origin to be facilitated.

### Embodiment 7

Next, Figure 18 is a structural diagram that shows part of a magnetic position sensor according to Embodiment 7 of the present invention. In this example, a fluctuation control gap g3 is disposed between a magnetic pole face of a magnet 10 near fixed cores 2 and 3 and the fixed cores 2 and 3.

The magnetic pole face of the magnet 10 near the fixed cores 2 and 3 projects toward the fixed cores 2 and 3 more than fixed-core-facing surfaces 8b and 9b. Conversely, spacing between the fixed-core-facing surfaces 8b and 9b and the fixed cores 2 and 3 is greater than spacing between the magnet 10 and the fixed cores 2 and 3. The rest of the configuration is similar to that of Embodiment 1.

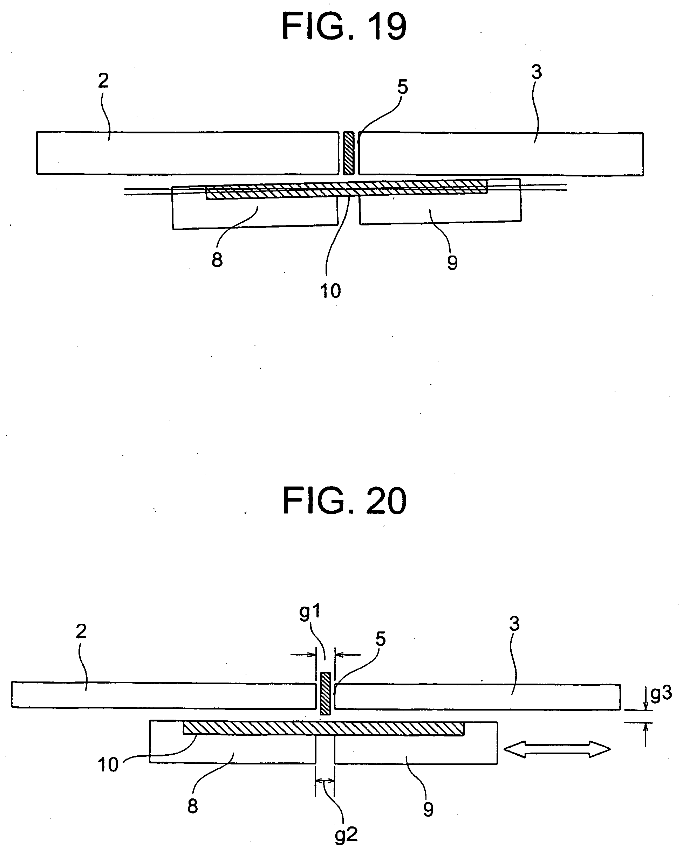

In a magnetic position sensor of this kind, errors that occur if the movable cores 8 and 9 and the magnet 10 are inclined relative to the fixed cores 2 and 3 can be reduced. As shown in Figure 19, for example, if the movable cores 8 and 9 and the magnet 10 are inclined, gap fluctuations in the fluctuation control gap g3 are increased in the vicinity of the fixed-core-facing surfaces 8b and 9b. In answer to that, resistance to gap fluctuations can be increased by increasing the distance between the fixed-core-facing surfaces 8b and 9b and the fixed cores 2 and 3.

### Embodiment 8

Next, Figure 20 is a structural diagram that shows part of a magnetic position sensor according to Embodiment 8 of the present invention. In this example, a fluctuation control gap g3 is disposed between movable cores 8 and 9 and fixed cores 2 and 3 and between a magnet 10 and the fixed cores 2 and 3.

End portions of a magnetic detecting element 5 project beyond the fixed cores 2 and 3 toward the magnet 10 and in an opposite direction thereto. Conversely, a thickness dimension of the fixed cores 2 and 3 is less than a dimension of the magnetic detecting element 5 in the same direction. The rest of the configuration is similar to that of Embodiment 1.

The thickness of the fixed cores 2 and 3 is set to so as to enable magnetic flux that is parallel to the magnetic detecting element 5 to be supplied. Even if a portion of the magnetic detecting element 5 projects beyond the fixed cores 2 and 3, it will not interfere with the magnet 10 if the fluctuation control gap g3 is disposed. Because of this, even if the thickness dimension of the fixed cores 2 and 3 is made smaller than the dimension of the magnetic detecting element 5 in the same direction, parallel magnetic flux can be supplied to the magnetically sensitive portion 5a, enabling reductions in size and weight and reductions in cost (material costs) in the magnetic position sensor.

### Embodiment 9

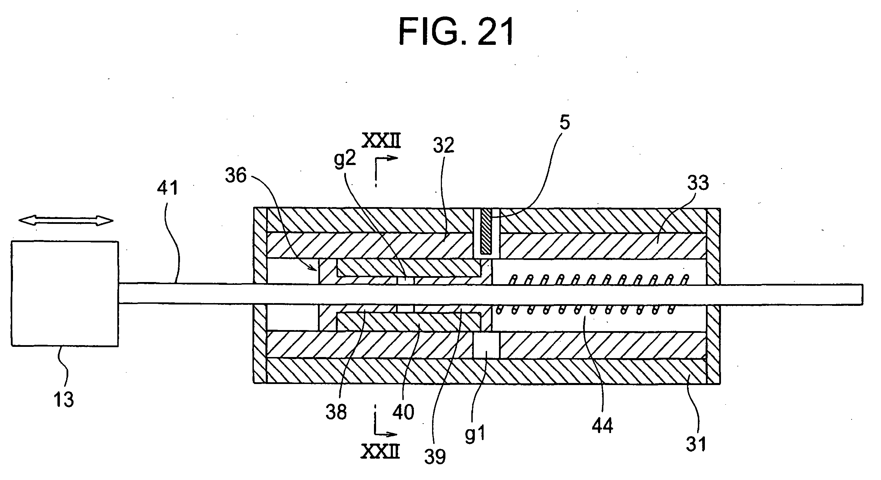

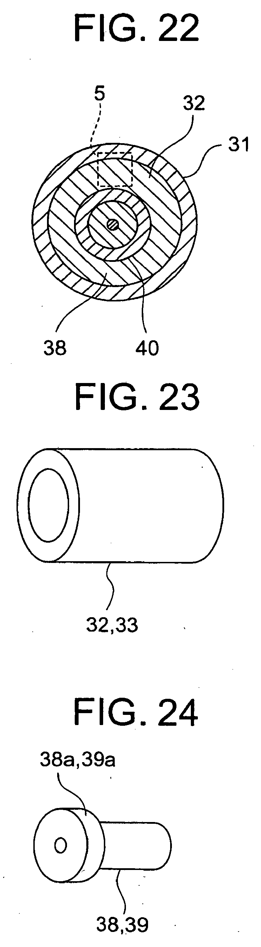

Next, Figure 21 is a cross section of a magnetic position sensor according to Embodiment 9 of the present invention, Figure 22 is a cross section taken along line XXII - XXII in Figure 21, Figure 23 is a perspective that shows a fixed core from Figure 21, and Figure 24 is a perspective that shows a movable core from Figure 21.

In the figures, cylindrical first and second fixed cores (detecting cores) 32 and 33 that are constituted by a ferromagnetic material such as iron, etc., for example, are fixed inside a cylindrical housing 31. The fixed cores 32 and 33 are disposed coaxially on opposite sides of a ring-shaped detecting gap g1. A magnetic detecting element 5 is disposed at one circumferential position in the detecting gap g1.

A movable body (a magnet unit) 36 that is displaceable by sliding along the fixed cores 32 and 33 in an axial direction of the fixed cores 32 and 33 (left-to-right in the figure) is disposed inside the fixed cores 32 and 33. The movable body 36 has: cylindrical first and second movable cores (magnet cores) 38 and 39 that are constituted by a ferromagnetic material such as iron, etc., for example; and a cylindrical magnet (a permanent magnet) 40.

Flange portions 38a and 39a are disposed on one axial end portion of the movable cores 38 and 39 as shown in Figure 24. Diameters of the flange portions 38a and 39a are greater than diameters of portions of the movable cores 38 and 39 that do not include the flange portions 38a and 39a. The movable cores 38 and 39 are disposed coaxially so as to have reverse orientations from each other such that end surfaces at opposite ends from the flange portions 38a and 39a face each other on opposite sides of a ring-shaped origin gap g2.

The magnet 40 surrounds the portions of the movable cores 38 and 39 that do not include the flange portions 38a and 39a, and the origin gap g2. The magnet 40 is magnetized so as to have two poles, and has a direction of magnetization that is in a radial direction (a wall thickness direction).

A shaft 41 that is made of a nonmagnetic material penetrates through the movable body 36. The movable cores 38 and 39 are fixed to the shaft 41. A measured object 13 is placed in contact with the shaft 41. A spring 44 that forces the movable body 36 and the shaft 41 toward the measured object 13 is disposed between the housing 31 and the movable body 36.

The configuration of the fixed cores 32 and 33, the movable cores 38 and 39, and the magnet 40 of a magnetic position sensor of this kind is equivalent to rotating the fixed cores 2 and 3, the movable cores 8 and 9, and the magnet 10 according to Embodiment 1 into a cylindrical shape. Consequently, the basic principles of position detection are similar to those of Embodiment 1, enabling the origin position to be adjusted so as to correspond to the place of use, and also enabling decreases in accuracy of measurement to be suppressed.

By forming each of the fixed cores 32 and 33, the movable cores 38 and 39, and the magnet 40 so as to have a cylindrical shape, accuracy of measurement can be improved since the construction becomes differential with respect to the errors generated by gap fluctuations.

In addition, magnetic flux density across the detecting gap g1 is made approximately uniform no matter which direction the movable cores 8 and 9 and the magnet 40 may be biased toward relative to the fixed cores 32 and 33 since the magnetic resistance of the air is extremely large compared to that of the fixed cores 32 and 33. Consequently, sufficient accuracy of measurement can be achieved even though the magnetic detecting element 5 is disposed only at a single circumferential position in the detecting gap g1.

Moreover, in Embodiment 9, each of the fixed cores 32 and 33, the movable cores 38 and 39, and the magnet 40 are formed so as to have a cylindrical shape, but they may also be formed into polygonal prisms that have three or more corner portions in cross section.

As shown in Embodiment 2, a stroke may also be asymmetric on two sides of the origin.

In addition, as shown in Embodiment 3, a fluctuation control gap may also be disposed between the fixed cores 32 and 33 and the movable cores 38 and 39 and and between the fixed cores 32 and 33 and the magnet 40.

As shown in Embodiment 4, a fluctuation control gap may also be disposed between a magnetic pole face of the magnet 40 near the movable cores 38 and 39 and the movable cores 38 and 39.

As shown in Embodiment 5, magnet end gaps may be disposed between two end surfaces in the direction of movement of the magnet 40 and the movable cores 38 and 39.

In addition, as shown in Embodiment 6, a dimension of the origin gap in the direction of movement of the movable cores 38 and 39 and the magnet 40 may also be greater than a dimension of the detecting gap in the same direction.

As shown in Embodiment 7, spacing between surfaces of the movable cores 38 and 39 that face the fixed cores 32 and 33 and the fixed cores 32 and 33 may also be set so as to be greater than spacing between the magnet 40 and the fixed cores 32 and 33.

As shown in Embodiment 8, end portions of the magnetic detecting element 5 may also project beyond the fixed cores 32 and 33 toward the magnet 40 and in an opposite direction thereto.

### Embodiment 10

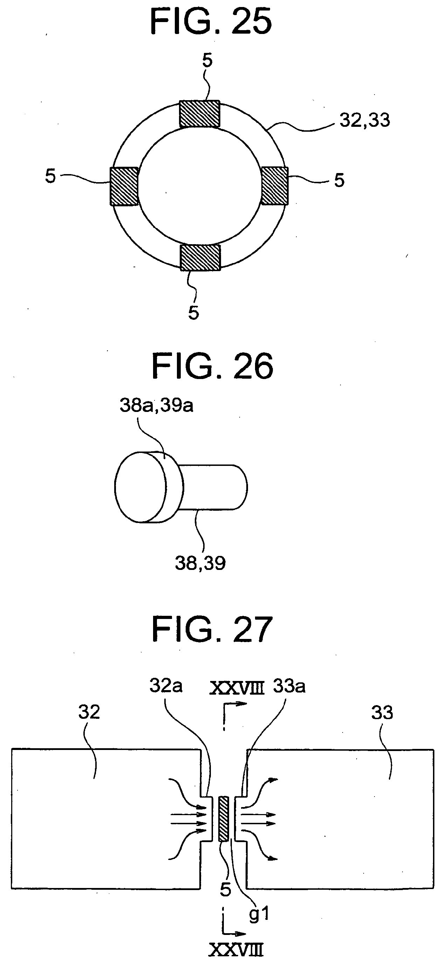

Next, Figure 25 is an explanatory diagram that shows relationships among first and second fixed cores 32 and 33 and magnetic detecting elements 5 of a magnetic position sensor according to Embodiment 10 of the present invention. In this example, four magnetic detecting elements 5 are disposed so as to be spaced apart from each other in a circumferential direction on the fixed cores 32 and 33. The rest of the configuration is similar to that of Embodiment 9.

In a magnetic position sensor of this kind, slight errors that are due to the position of the magnetic flux density that passes across the detecting gap g1 can be corrected by averaging output from the four magnetic detecting elements 5, enabling accuracy of measurement to be improved further.

### Embodiment 11

Next, Figure 26 is a perspective that shows movable cores 38 and 39 of a magnetic position sensor according to Embodiment 11 of the present invention. In this example, the movable cores 38 and 39 are formed so as to have solid cylindrical shapes without disposing hollow portions in the movable cores 38 and 39. The rest of the configuration is similar to that of Embodiment 9.

By omitting penetrating apertures from the movable cores 38 and 39 in this manner, construction of the movable cores 38 and 39 is simplified, enabling preparation costs to be reduced.

### Embodiment 12

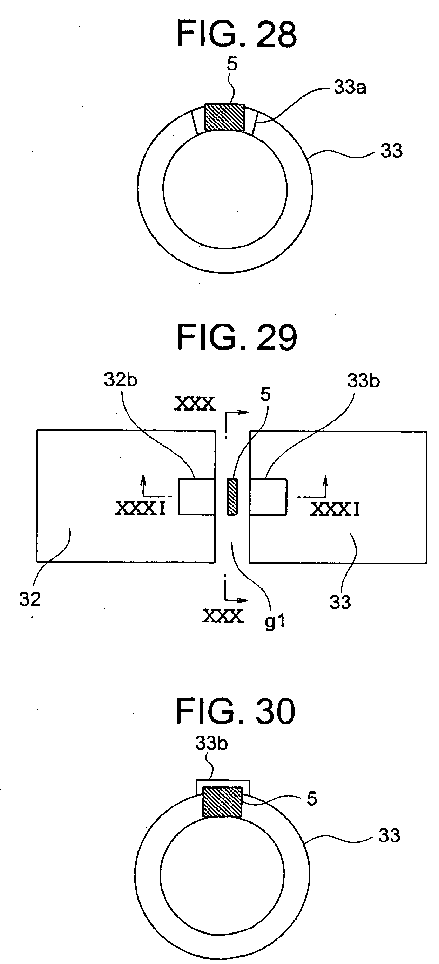

Next, Figure 27 is a structural diagram that shows part of a magnetic position sensor according to Embodiment 12 of the present invention, and Figure 28 is a cross section taken along line XXVIII - XXVIII in Figure 27. In the figures, protruding portions 32a and 33a that project toward a magnetic detecting element 5 are disposed on circumferential portions of end surfaces of fixed cores 32 and 33 that face each other. The rest of the configuration is similar to that of Embodiment 9.

In a magnetic position sensor of this kind, magnetic resistance can be reduced between the protruding portions 32a and 33a, enabling sufficient accuracy of measurement to be obtained even if a magnetically weak magnet 40 (see Figure 21) is used.

### Embodiment 13

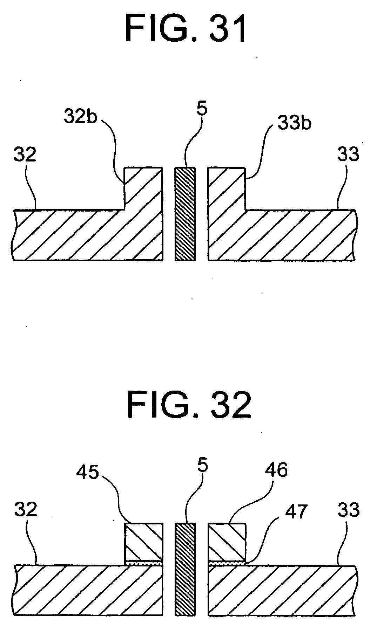

Next, Figure 29 is a structural diagram that shows part of a magnetic position sensor according to Embodiment 13 of the present invention, Figure 30 is a cross section taken along line XXX - XXX in Figure 29, and Figure 31 is a cross section taken along line XXXI - XXXI in Figure 29.

In the figures, protruding portions 32b and 33b that project radially outward are disposed on end portions of fixed cores 32 and 33 that face each other. The protruding portions 32b and 33b are disposed on the fixed cores 32 and 33 at circumferential positions that align with a magnetic detecting element 5. In other words, a portion of the magnetic detecting element 5 is disposed between the protruding portions 32b and 33b. The rest of the configuration is similar to that of Embodiment 9.

In a magnetic position sensor of this kind, because the protruding portions 32b and 33b are disposed on outer circumferential portions of the fixed cores 32 and 33 and the magnetic detecting element 5 is disposed between the protruding portions 32b and 33b, wall thickness of portions of the fixed cores 32 and 33 that do not include the protruding portions 32b and 33b can be made thinner while ensuring a supply of magnetic flux to the magnetic detecting element 5. Thus, reductions in overall size and weight of the sensor can be achieved.

### Embodiment 14

Next, Figure 32 is a partial cross section of a magnetic position sensor according to Embodiment 14 of the present invention. In this example, protruding portions 45 and 46 that are separate parts from fixed cores 32 and 33 are mounted to outer circumferential portions of the fixed cores 32 and 33 instead of the protruding portions 32b and 33b of Embodiment 13. The protruding portions 45 and 46 are fixed to the fixed cores 32 and 33 using an adhesive 47, for example.

Thus, if gaps between the fixed cores 32 and 33 and the protruding portions 45 and 46 are sufficiently small compared to the detecting gap g1, it is possible to configure the protruding portions 45 and 46 as separate parts from the fixed cores 32 and 33, enabling wall thickness of the fixed cores 32 and 33 to be made thinner without complicating the construction of the fixed cores 32 and 33.

### Embodiment 15

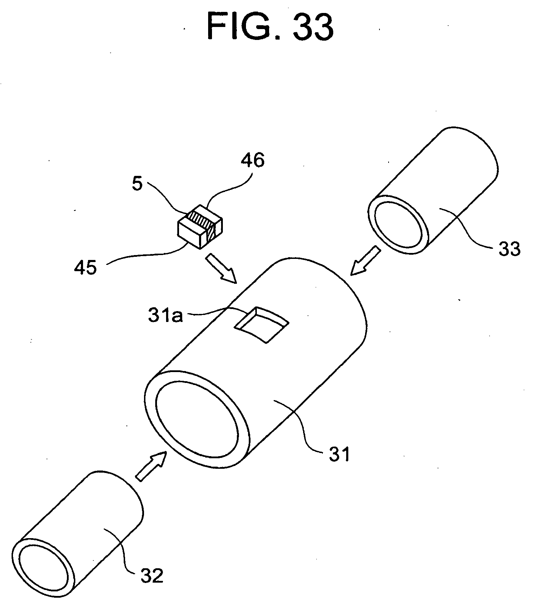

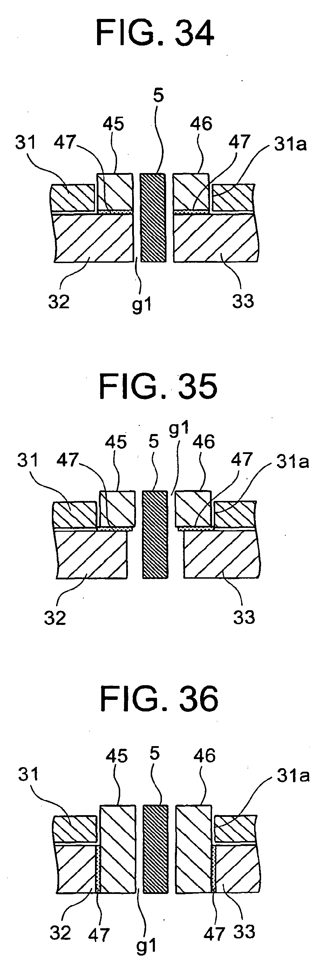

Next, Figure 33 is an exploded perspective that shows part of a magnetic position sensor according to Embodiment 15 of the present invention, and Figure 34 is a partial cross section of the magnetic position sensor in Figure 33. In the figures, an opening portion (a window portion) 31a is disposed on an axially intermediate portion of a housing 31. Protruding portions 45 and 46 are inserted into the opening portion 31 a, and are fixed adhesively to outer circumferential portions of fixed cores 32 and 33. A magnetic detecting element 5 is passed through the opening portion 31 a and disposed in a detecting gap g1.

In a magnetic position sensor of this kind, because the opening portion 31a is disposed on the housing 31, it is possible to mount the protruding portions 45 and 46 and the magnetic detecting element 5 after the fixed cores 32 and 33 have been inserted into the housing 31, enabling the shapes of the housing 31 and the fixed cores 32 and 33 to be simplified, and positioning between the protruding portions 45 and 46 and the fixed cores 32 and 33 and between the magnetic detecting element 5 and the fixed cores 32 and 33 is facilitated.

Moreover, the magnetic detecting element 5 may also be fixed between the protruding portions 45 and 46 before the protruding portions 45 and 46 are inserted in the opening portion 31a. In that case, adhesive or nonmagnetic spacers, etc., may also be interposed between the protruding portions 45 and 46 and the magnetic detecting element 5.

### Embodiment 16

Next, Figure 35 is a partial cross section of a magnetic position sensor according to Embodiment 16 of the present invention. In this example, spacing between protruding portions 45 and 46 (a detecting gap g1) is smaller than spacing between fixed cores 32 and 33. The rest of the configuration is similar to that of Embodiment 15.

By configuring in this manner, magnetic resistance can be reduced between the protruding portions 45 and 46 in a similar manner to Embodiment 12, enabling sufficient accuracy of measurement to be obtained even if a magnetically weak magnet 40 (see Figure 21) is used.

### Embodiment 17

Next, Figure 36 is a partial cross section of a magnetic position sensor according to Embodiment 17 of the present invention. In this example, protruding portions 45 and 46 are fixed adhesively to axial end surfaces rather than outer circumferential portions of fixed cores 32 and 33. Similar effects to those of Embodiment 15 can also be achieved using this kind of construction.

### Embodiment 18

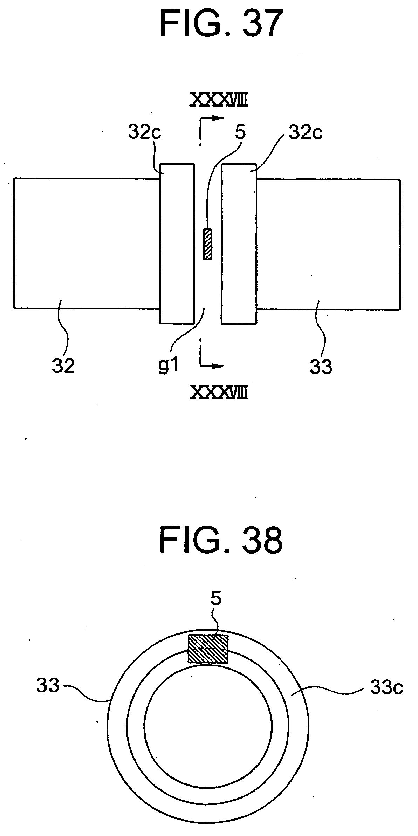

Next, Figure 37 is a structural diagram that shows part of a magnetic position sensor according to Embodiment 18 of the present invention, and Figure 38 is a cross section taken along line XXXVIII - XXXVIII in Figure 37. In the figures, protruding portions 32c and 33c that project radially outward are disposed on end portions of fixed cores 32 and 33 that face each other. The protruding portions 32c and 33c are disposed around entire circumferences of the fixed cores 32 and 33. The rest of the configuration is similar to that of Embodiment 13.

In a magnetic position sensor of this kind, because the protruding portions 32c and 33c are disposed on outer circumferential portions of the fixed cores 32 and 33 and the magnetic detecting element 5 is disposed between the protruding portions 32c and 33c, wall thickness of portions of the fixed cores 32 and 33 that do not include the protruding portions 32c and 33c can be made thinner while ensuring a supply of magnetic flux to the magnetic detecting element 5. Thus, reductions in overall size and weight of the sensor can be achieved. Because the protruding portions 32c and 33c are disposed around the entire circumferences of the fixed cores 32 and 33, shapes of the fixed cores 32 and 33 can be simplified.

### Embodiment 19

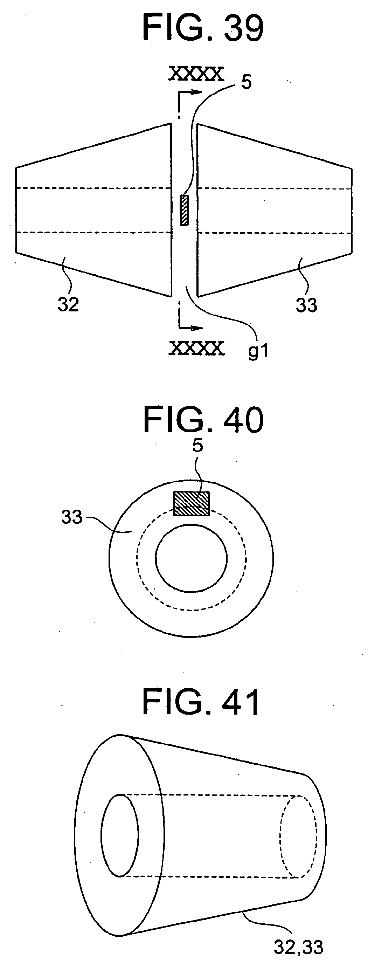

Next, Figure 39 is a structural diagram that shows part of a magnetic position sensor according to Embodiment 19 of the present invention, Figure 40 is a cross section taken along line XXXX - XXXX in Figure 39, and Figure 41 is a perspective that shows a fixed core from Figure 39.

In this example, outside diameters of fixed cores 32 and 33 are changed continuously in an axial direction of the fixed cores 32 and 33 instead of disposing protruding portions 32c and 33c on end portions of the fixed cores 32 and 33. Specifically, outside diameters of end portions of the fixed cores 32 and 33 that face each other are greater than outside diameters of end portions at opposite ends. However, inside diameters of the fixed cores 32 and 33 are constant in the axial direction. The rest of the configuration is similar to that of Embodiment 9.

In a magnetic position sensor of this kind, because the outside diameters of the end portions of the fixed cores 32 and 33 near the magnetic detecting element 5 are formed so as to be larger than the end portions at the opposite ends, wall thickness of the fixed cores 32 and 33 can be made gradually thinner toward the end portions at opposite ends from the magnetic detecting element 5 while ensuring a supply of magnetic flux to the magnetic detecting element 5. Thus, reductions in overall size and weight of the sensor can be achieved.

### Embodiment 20

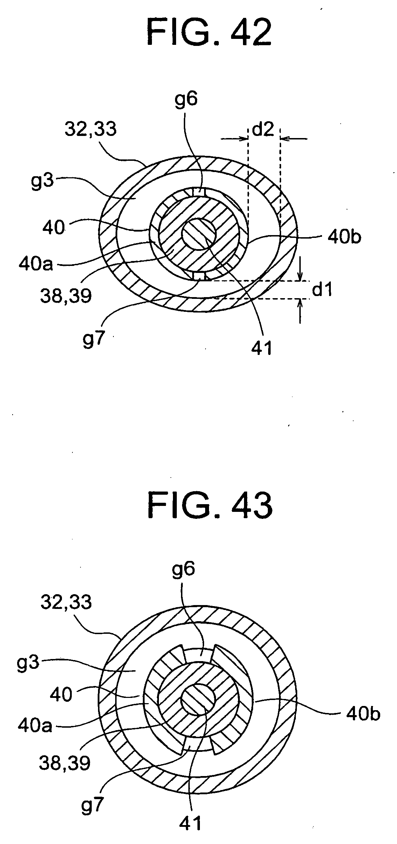

Next, Figure 42 is a partial cross section of a magnetic position sensor according to Embodiment 20 of the present invention. In the figure, a magnet 40 is divided into a plurality of parts circumferentially. Specifically, the magnet 40 is divided into first and second magnet segments 40a and 40b that have semicircular cross sections. Magnet segment gaps g6 and g7 are disposed between the magnet segments 40a and 40b. A fluctuation control gap g3 such as that explained in Embodiment 3 is disposed between movable cores 38 and 39 and fixed cores 32 and 33 and between the magnet 40 and the fixed cores 32 and 33.

Cross sections of the fixed cores 32 and 33 are elliptical. The size of the fluctuation control gap g3 in a circumferential direction of the sensor is formed so as to be smallest (d1) in vicinities of the magnet segment gaps g6 and g7, and formed so as to be largest (d2) at positions that are farthest away from the magnet segment gaps g6 and g7. The rest of the configuration is similar to that of Embodiment 9.

By dividing the cylindrical magnet 40 into the magnet segments 40a and 40b in this manner, manufacturing of the magnet 40 can be facilitated. By disposing the magnet segment gaps g6 and g7 between the magnet segments 40a and 40b, manufacturing precision for the magnet segments 40a and 40b can be lowered, and assembly of the magnet segments 40a and 40b onto the movable cores 38 and 39 can be facilitated.

However, if the magnet segment gaps g6 and g7 are disposed, effects of the differential construction that result from forming the sensor so as to have a cylindrical shape are reduced since magnetic flux density is reduced at portions near the magnet segment gaps g6 and g7. In answer to this, the strength of the magnetic flux loops is made uniform in a circumferential direction of the sensor by making the size of the fluctuation control gap g3 smaller at positions near the magnet segment gaps g6 and g7 than at other positions, enabling reductions in the effects due to the differential construction to be suppressed.

### Embodiment 21

Next, Figure 43 is a partial cross section of a magnetic position sensor according to Embodiment 21 of the present invention. In this example, cross sections of fixed cores 32 and 33 are circular. Thickness dimensions of the cross sections of magnet segments 40a and 40b are greatest at two end portions that are adjacent to magnet segment gaps g6 and g7, and are smallest at intermediate portions. The rest of the configuration is similar to that of Embodiment 20.

In a magnetic position sensor of this kind, because the magnetic flux density is proportional to the wall thickness of the magnet 40, the magnetic flux density in the vicinity of the magnet segment gaps g6 and g7 is increased by making the wall thickness of the magnet segments 40a and 40b in the vicinity of the magnet segment gaps g6 and g7 thicker than the wall thickness in other portions, enabling the strength of the magnetic flux loops to be made uniform in the circumferential direction of the sensor.

### Embodiment 22

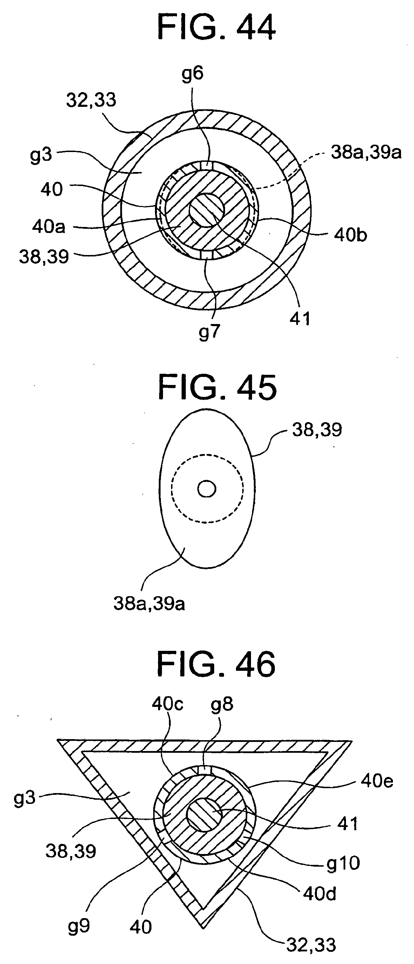

Next, Figure 44 is a partial cross section of a magnetic position sensor according to Embodiment 22 of the present invention, and Figure 45 is a front elevation that shows a movable core from Figure 44. In the figures, cross sections of flange portions 38a and 39a of movable cores 38 and 39 are elliptical. Specifically, distances between outer circumferential surfaces of the flange portions 38a and 39a and inner circumferential surfaces of fixed cores 32 and 33 in a circumferential direction of the sensor are smallest in vicinities of magnet segment gaps g6 and g7, and are largest at positions that are farthest away from the magnet segment gaps g6 and g7. The rest of the configuration is similar to that of Embodiment 20.

Thus, the strength of the magnetic flux loops can be made uniform in the circumferential direction of the sensor even if outer circumferential shapes of the flange portions 38a and 39a are modified so as to increase the magnetic flux density at positions near the magnet segment gaps g6 and g7.

### Embodiment 23

Next, Figure 46 is a partial cross section of a magnetic position sensor according to Embodiment 23 of the present invention. In the figure, a magnet 40 is divided into first through third magnet segments 40c through 40e that have arc-shaped cross sections. Magnet segment gaps g8 through g10 are disposed between the magnet segments 40c through 40e. A fluctuation control gap g3 such as that explained in Embodiment 3 is disposed between movable cores 38 and 39 and fixed cores 32 and 33 and between the magnet 40 and the fixed cores 32 and 33.

Cross sections of the fixed cores 32 and 33 are triangular. The size of the fluctuation control gap g3 in a circumferential direction of the sensor is smallest in the vicinities of the magnet segment gaps g8 through g10, and largest at positions that are farthest away from the magnet segment gaps g8 through g10. The rest of the configuration is similar to that of Embodiment 9.

By forming the cross-sectional shapes of the fixed cores 32 and 33 into polygons that correspond to the number of magnet segment gaps g8 through g10 in this manner, the size of the fluctuation control gap g3 can also be made smaller at positions near the magnet segment gaps g6 and g7 than at other positions, making the strength of the magnetic flux loops uniform in a circumferential direction of the sensor and enabling reductions in the effects due to the differential construction to be suppressed.

Moreover, use of a magnetic position sensor according to the present invention is not limited to elevator weighing apparatuses and valve opening measuring apparatuses.

In the above examples, first and second detecting cores were fixed, and the magnet unit was movable, but that may also be reversed.

In addition, if the first and second detecting cores, the first and second magnet cores, and the magnet are formed so as to be tubular, the first and second detecting cores can also be disposed inside the magnet unit.

## Claims

1. A magnetic position sensor comprising:
first and second detecting cores (2 and 3, 32 and 33) that are disposed so as to line up with each other on opposite sides of a detecting gap (g1);
a magnet unit (6, 36) having:
first and second magnet cores (8 and 9, 38 and 39) that are disposed so as to line up with each other on opposite sides of an origin gap (g2); and
a magnet (10, 40) that generates two magnetic flux loops between the first and second detecting cores (2 and 3, 32 and 33) and the first and second magnet cores (8 and 9, 38 and 39), the magnetic flux loops having a boundary at the origin gap (g2),
the magnet unit being displaced relative to the first and second detecting cores (2 and 3, 32 and 33) together with displacement of a measured object; and
a magnetic detecting element (5) that is disposed in the detecting gap (g1), and that detects magnetic flux that passes through the detecting gap (g1).

2. The magnetic position sensor according to Claim 1, wherein an end portion of the magnet (10, 40) near the magnetic detecting element (5) overlaps with the first and second detecting cores (2 and 3, 32 and 33) even if the magnet unit (6, 36) moves to a maximum stroke position that enables position detection.

3. The magnetic position sensor according to Claim 1, wherein the first and second magnet cores (8 and 9, 38 and 39) are positioned within limits of the first and second detecting cores (2 and 3, 32 and 33) even if the magnet unit (6, 36) moves to a maximum stroke position that enables position detection.

4. The magnetic position sensor according to Claim 1, wherein a fluctuation control gap (g3) that suppresses fluctuations in magnetic flux density due to displacement of the magnet unit (6, 36) in a direction toward or away from the first and second detecting cores (2 and 3, 32 and 33) is disposed between the first and second magnet cores (8 and 9, 38 and 39) and the first and second detecting cores (2 and 3, 32 and 33) and between the magnet (10, 40) and the first and second detecting cores (2 and 3, 32 and 33).

5. The magnetic position sensor according to Claim 4, wherein an end portion of the magnetic detecting element (5) projects from the first and second detecting cores (2 and 3, 32 and 33) toward the magnet (10, 40).

6. The magnetic position sensor according to Claim 1, wherein a fluctuation control gap (g4) that suppresses fluctuations in magnetic flux density due to displacement of the magnet unit (6, 36) in a direction toward or away from the first and second detecting cores (2 and 3, 32 and 33) is disposed between a magnetic pole face of the magnet (10, 40) near the first and second magnet cores (8 and 9, 38 and 39) and the first and second magnet cores (8 and 9, 38 and 39).

7. The magnetic position sensor according to Claim 1, wherein a magnet end gap (g5) is disposed between an end surface of the magnet (10, 40) in a direction of movement of the magnet unit (6, 36) and the first and second magnet cores (8 and 9, 38 and 39).

8. The magnetic position sensor according to Claim 1, wherein a dimension of the origin gap (g2) in a direction of movement of the magnet unit (6, 36) is greater than a dimension of the detecting gap (g1) in the direction.

9. The magnetic position sensor according to Claim 1, wherein:
the first and second detecting cores (32 and 33), the first and second magnet cores (38 and 39), and the magnet (40) are tubular; and
the magnet unit (36) is disposed inside the first and second detecting cores (32 and 33).

10. The magnetic position sensor according to Claim 9, wherein protruding portions (32a and 33a, 32c and 33c) that project toward the magnetic detecting element (5) are respectively disposed on circumferential portions of end surfaces of the first and second detecting cores (32 and 33) that face each other.

11. The magnetic position sensor according to Claim 9, wherein:
protruding portions (32b and 33b, 45 and 46) that project radially outward are respectively disposed on end portions of the first and second detecting cores (32 and 33) that face each other; and
the magnetic detecting element (5) is disposed between the protruding portions (32b and 33b, 45 and 46).

12. The magnetic position sensor according to Claim 11, wherein the protruding portions (45 and 46) are configured as separate parts from the first and second detecting cores (32 and 33) and are mounted onto the first and second detecting cores (32 and 33).

13. The magnetic position sensor according to Claim 9, wherein:
a fluctuation control gap (g3) that suppresses fluctuations in magnetic flux density due to displacement of the magnet unit (36) in a direction toward or away from the first and second detecting cores (32 and 33) is disposed between the first and second magnet cores (38 and 39) and the first and second detecting cores (32 and 33) and between the magnet (40) and the first and second detecting cores (32 and 33);
the magnet (40) is divided into a plurality of magnet segments (40a, 40b, 40c) circumferentially;
at least one magnet segment gap (g6, g7, g8) is disposed between the magnet segments (40a, 40b, 40c); and
a cross-sectional shape of the first and second detecting cores (32 and 33) is modified such that a size of the fluctuation control gap (g3) is smaller at a position near the magnet segment gap (g6, g7, g8) than at other positions.

14. The magnetic position sensor according to Claim 13, wherein the cross-sectional shape of the first and second detecting cores (32 and 33) is polygonal.

15. The magnetic position sensor according to Claim 9, wherein:
the magnet (40) is divided into a plurality of magnet segments (40a, 40b, 40c) circumferentially;
at least one magnet segment gap (g6, g7, g8) is disposed between the magnet segments (40a, 40b, 40c); and
a wall thickness of the magnet segments (40a, 40b, 40c) is thicker in a vicinity of the magnet segment gap (g6, g7, g8) than in other portions.

16. The magnetic position sensor according to Claim 9, wherein:
a fluctuation control gap (g3) that suppresses fluctuations in magnetic flux density due to displacement of the magnet unit (36) in a direction toward or away from the first and second detecting cores (32 and 33) is disposed between the first and second magnet cores (38 and 39) and the first and second detecting cores (32 and 33) and between the magnet (40) and the first and second detecting cores (32 and 33);
the first and second magnet cores (38 and 39) respectively have flange portions (38a and 39a) that face an inner circumferential surface of the first and second detecting cores (32 and 33);
the magnet (40) is divided into a plurality of magnet segments (40a, 40b, 40c) circumferentially;
at least one magnet segment gap (g6, g7, g8) is disposed between the magnet segments (40a, 40b, 40c); and
an outer circumferential shape of the flange portions (38a and 39a) is modified such that a distance between the flange portions (38a and 39a) and the inner circumferential surface of the first and second detecting cores (32 and 33) is reduced in a vicinity of the magnet segment gap (g6, g7, g8).

## Patentansprüche

1. Magnetischer Positionssensor, mit:
einem ersten und einem zweiten Erfassungskern (2 und 3, 32 und 33), die angeordnet sind, um sich an gegenüberliegenden Seiten eines Erfassungsspalts (g1) miteinander aufzustellen;
einer Magneteinheit (6, 36), die aufweist:
einen ersten und einen zweiten Magnetkern (8 und 9, 38 und 39), die angeordnet sind, um sich an gegenüberliegenden Seiten eines Ursprungsspalts (g2) miteinander aufzustellen; und
einen Magnet (10, 40), der zwischen den ersten und zweiten Erfassungskernen (2 und 3, 32 und 33) und den ersten und zweiten Magnetkernen (8 und 9, 38 und 39) zwei Magnetflussschleifen erzeugt, wobei die Magnetflussschleifen eine Grenze an dem Ursprungsspalt (g2) aufweisen,
wobei die Magneteinheit relativ zu den ersten und zweiten Erfassungskernen (2 und 3, 32 und 33) zusammen mit einer Verschiebung eines gemessenen Objekts verschoben ist; und
einem magnetische-Erfassung-Element (5), das in dem Erfassungsspalt (g1) angeordnet ist, und das einen Magnetfluss erfasst, der durch den Erfassungsspalt (g1) durchgeht.

2. Magnetischer Positionssensor nach Anspruch 1, wobei ein Endabschnitt des Magneten (10, 40) nahe dem magnetische-Erfassung-Element (5) mit den ersten und zweiten Erfassungskernen (2 und 3, 32 und 33) überlappt, sogar falls sich die Magneteinheit (6, 36) zu einer Maximalhubposition bewegt, die eine Positionserfassung ermöglicht.

3. Magnetischer Positionssensor nach Anspruch 1, wobei die ersten und zweiten Magnetkerne (8 und 9, 38 und 39) innerhalb von Grenzen der ersten und zweiten Erfassungskerne (2 und 3, 32 und 33) positioniert sind, sogar falls sich die Magneteinheit (6, 36) zu einer Maximalhubposition bewegt, die eine Positionserfassung ermöglicht.

4. Magnetischer Positionssensor nach Anspruch 1, wobei ein Schwankungssteuerungsspalt (g3), der Magnetflussdichte-Schwankungen aufgrund einer Verschiebung der Magneteinheit (6, 36) in eine Richtung zu den ersten und zweiten Erfassungskernen (2 und 3, 32 und 33) hin oder weg von ihnen unterdrückt, zwischen den ersten und zweiten Magnetkernen (8 und 9, 38 und 39) und den ersten und zweiten Erfassungskernen (2 und 3, 32 und 33), und zwischen dem Magnet (10, 40) und den ersten und zweiten Erfassungskernen (2 und 3, 32 und 33), angeordnet ist.

5. Magnetischer Positionssensor nach Anspruch 4, wobei ein Endabschnitt des magnetische-Erfassung-Elements (5) von den ersten und zweiten Erfassungskernen (2 und 3, 32 und 33) zu dem Magneten (10, 40) hin vorsteht.

6. Magnetischer Positionssensor nach Anspruch 1, wobei ein Schwankungssteuerungsspalt (g4), der Magnetflussdichte-Schwankungen aufgrund einer Verschiebung der Magneteinheit (6, 36) in eine Richtung zu den ersten und zweiten Erfassungskernen (2 und 3, 32 und 33) hin oder weg von ihnen unterdrückt, zwischen einer Magnetpolfläche des Magneten (10, 40) nahe den ersten und zweiten Magnetkernen (8 und 9, 38 und 39) und den ersten und zweiten Magnetkernen (8 und 9, 38 und 39) angeordnet ist.

7. Magnetischer Positionssensor nach Anspruch 1, wobei ein Magnetendspalt (g5) zwischen einer Endoberfläche des Magneten (10, 40) in einer Richtung einer Bewegung der Magneteinheit (6, 36) und den ersten und zweiten Magnetkernen (8 und 9, 38 und 39) angeordnet ist.

8. Magnetischer Positionssensor nach Anspruch 1, wobei eine Abmessung des Ursprungsspalts (g2) in eine Richtung einer Bewegung der Magneteinheit (6, 36) größer als eine Abmessung des Erfassungsspalts (g1) in die Richtung ist.

9. Magnetischer Positionssensor nach Anspruch 1, wobei:
die ersten und zweiten Erfassungskerne (32 und 33), die ersten und zweiten Magnetkerne (38 und 39) und der Magnet (40) rohrförmig sind; und
die Magneteinheit (36) im Inneren der ersten und zweiten Erfassungskerne (32 und 33) angeordnet ist.

10. Magnetischer Positionssensor nach Anspruch 9, wobei vorstehende Abschnitte (32a und 33a, 32c und 33c), die zu dem magnetische-Erfassung-Element (5) hin vorstehen, an Umfangsabschnitten von Endoberflächen der ersten und zweiten Erfassungskerne (32 und 33), die einander zugewandt sind, entsprechend angeordnet sind.

11. Magnetischer Positionssensor nach Anspruch 9, wobei:
vorstehende Abschnitte (32b und 33b, 45 und 46), die radial nach außen vorstehen, an Endabschnitten der ersten und zweiten Erfassungskerne (32 und 33), die einander zugewandt sind, entsprechend angeordnet sind; und
das magnetische-Erfassung-Element (5) zwischen den vorstehenden Abschnitten (32b und 33b, 45 und 46) angeordnet ist.

12. Magnetischer Positionssensor nach Anspruch 11, wobei die vorstehenden Abschnitte (45 und 46) als separate Teile von den ersten und zweiten Erfassungskernen (32 und 33) ausgestaltet sind, und auf die ersten und zweiten Erfassungskerne (32 und 33) montiert sind.

13. Magnetischer Positionssensor nach Anspruch 9, wobei:
ein Schwankungssteuerungsspalt (g3), der Magnetflussdichte-Schwankungen aufgrund einer Verschiebung der Magneteinheit (36) in eine Richtung zu den ersten und zweiten Erfassungskernen (32 und 33) hin oder weg von ihnen unterdrückt, zwischen den ersten und zweiten Magnetkernen (38 und 39) und den ersten und zweiten Erfassungskernen (32 und 33), und zwischen dem Magnet (40) und den ersten und zweiten Erfassungskernen (32 und 33), angeordnet ist;
der Magnet (40) umfänglich in eine Vielzahl an Magnetsegmenten (40a, 40b, 40c) unterteilt ist;
zumindest ein Magnetsegmentspalt (g6, g7, g8) zwischen den Magnetsegmenten (40a, 40b, 40c) angeordnet ist; und
eine Querschnittform der ersten und zweiten Erfassungskerne (32 und 33) derart modifiziert ist, dass eine Größe des Schwankungssteuerungsspalts (g3) an einer Position nahe dem Magnetsegmentspalt (g6, g7, g8) kleiner als an anderen Positionen ist.

14. Magnetischer Positionssensor nach Anspruch 13, wobei die Querschnittform der ersten und zweiten Erfassungskerne (32 und 33) polygonal ist.

15. Magnetischer Positionssensor nach Anspruch 9, wobei:
der Magnet (40) umfänglich in eine Vielzahl an Magnetsegmenten (40a, 40b, 40c) unterteilt ist;
zumindest ein Magnetsegmentspalt (g6, g7, g8) zwischen den Magnetsegmenten (40a, 40b, 40c) angeordnet ist; und
eine Wanddicke der Magnetsegmente (40a, 40b, 40c) in einer Umgebung des Magnetsegmentspalts (g6, g7, g8) dicker als in anderen Abschnitten ist.

16. Magnetischer Positionssensor nach Anspruch 9, wobei:
ein Schwankungssteuerungsspalt (g3), der Magnetflussdichte-Schwankungen aufgrund einer Verschiebung der Magneteinheit (36) in eine Richtung zu den ersten und zweiten Erfassungskernen (32 und 33) hin oder weg von ihnen unterdrückt, zwischen den ersten und zweiten Magnetkernen (38 und 39) und den ersten und zweiten Erfassungskernen (32 und 33), und zwischen dem Magnet (40) und den ersten und zweiten Erfassungskernen (32 und 33), angeordnet ist;
die ersten und zweiten Magnetkerne (38 und 39) entsprechend Flanschabschnitte (38a und 39a) aufweisen, die einer inneren Umfangsoberfläche der ersten und zweiten Erfassungskerne (32 und 33) zugewandt sind;
der Magnet (40) umfänglich in eine Vielzahl an Magnetsegmenten (40a, 40b, 40c) unterteilt ist;
zumindest ein Magnetsegmentspalt (g6, g7, g8) zwischen den Magnetsegmenten (40a, 40b, 40c) angeordnet ist; und
eine äußere Umfangsform der Flanschabschnitte (38a und 39a) derart modifiziert ist, dass ein Abstand zwischen den Flanschabschnitten (38a und 39a) und der inneren Umfangsoberfläche der ersten und zweiten Erfassungskerne (32 und 33) in einer Umgebung des Magnetsegmentspalts (g6, g7, g8) verringert ist.

## Revendications

1. Détecteur de position magnétique comprenant :
des premier et deuxième noyaux de détection (2 et 3, 32 et 33) qui sont disposés de manière à s'aligner l'un avec l'autre sur des côtés opposés d'un entrefer de détection (g1) ;
une unité magnétique (6, 36) comportant :
des premier et deuxième noyaux magnétiques (8 et 9, 38 et 39) qui sont disposés de manière à s'aligner l'un avec l'autre sur des côtés opposés d'un entrefer d'origine (g2) ; et
un aimant (10, 40) qui génère deux boucles de flux magnétique entre les premier et deuxième noyaux de détection (2 et 3, 32 et 33) et les premier et deuxième noyaux magnétiques (8 et 9, 38 et 39), les boucles de flux magnétique comportant une frontière au niveau de l'entrefer d'origine (g2),
l'unité magnétique étant déplacée par rapport aux premier et deuxième noyaux de détection (2 et 3, 32 et 33) solidairement avec un déplacement d'un objet mesuré ; et
un élément de détection magnétique (5) qui est disposé dans l'entrefer de détection (g1) et qui détecte un flux magnétique traversant l'entrefer de détection (g1).

2. Détecteur de position magnétique selon la revendication 1, dans lequel une portion d'extrémité de l'aimant (10, 40) à proximité de l'élément de détection magnétique (5) chevauche les premier et deuxième noyaux de détection (2 et 3, 32 et 33) même si l'unité magnétique (6, 36) se déplace à une position de course maximale permettant une détection de position.

3. Détecteur de position magnétique selon la revendication 1, dans lequel les premier et deuxième noyaux magnétiques (8 et 9, 38 et 39) sont positionnés à l'intérieur de limites des premier et deuxième noyaux de détection (2 et 3, 32 et 33) même si l'unité magnétique (6, 36) se déplace à une position de course maximale permettant une détection de position.

4. Détecteur de position magnétique selon la revendication 1, dans lequel un entrefer de régulation de fluctuation (g3) qui supprime des fluctuations de densité de flux magnétique en raison d'un déplacement de l'unité magnétique (6, 36) dans un sens à destination ou à l'écart des premier et deuxième noyaux de détection (2 et 3, 32 et 33) est disposé entre les premier et deuxième noyaux magnétiques (8 et 9, 38 et 39) et les premier et deuxième noyaux de détection (2 et 3, 32 et 33) et entre l'aimant (10, 40) et les premier et deuxième noyaux de détection (2 et 3, 32 et 33).

5. Détecteur de position magnétique selon la revendication 4, dans lequel une portion d'extrémité de l'élément de détection magnétique (5) fait saillie des premier et deuxième noyaux de détection (2 et 3, 32 et 33) vers l'aimant (10, 40).

6. Détecteur de position magnétique selon la revendication 1, dans lequel un entrefer de régulation de fluctuation (g4) qui supprime des fluctuations de densité de flux magnétique en raison d'un déplacement de l'unité magnétique (6, 36) dans un sens à destination ou à l'écart des premier et deuxième noyaux de détection (2 et 3, 32 et 33) est disposé entre une face de pôle magnétique de l'aimant (10, 40) à proximité des premier et deuxième noyaux magnétiques (8 et 9, 38 et 39) et les premier et deuxième noyaux magnétiques (8 et 9, 38 et 39).

7. Détecteur de position magnétique selon la revendication 1, dans lequel un entrefer d'extrémité d'aimant (g5) est disposé entre une surface d'extrémité de l'aimant (10, 40) dans un sens de mouvement de l'unité magnétique (6, 36) et les premier et deuxième noyaux magnétiques (8 et 9, 38 et 39).

8. Détecteur de position magnétique selon la revendication 1, dans lequel une dimension de l'entrefer d'origine (g2) dans un sens de mouvement de l'unité magnétique (6, 36) est supérieure à une dimension de l'entrefer de détection (g1) dans le sens.

9. Détecteur de position magnétique selon la revendication 1, dans lequel :
les premier et deuxième noyaux de détection (32 et 33), les premier et deuxième noyaux magnétiques (38 et 39), et l'aimant (40) sont tubulaires ; et
l'unité magnétique (36) est disposée à l'intérieur des premier et deuxième noyaux de détection (32 et 33).

10. Détecteur de position magnétique selon la revendication 9, dans lequel des portions protubérantes (32a et 33a, 32c et 33c) qui font saillie vers l'élément de détection magnétique (5) sont respectivement disposées sur des portions circonférentielles de surfaces d'extrémité des premier et deuxième noyaux de détection (32 et 33) se faisant face l'une à l'autre.

11. Détecteur de position magnétique selon la revendication 9, dans lequel :
des portions protubérantes (32b et 33b, 45 et 46) qui font saillie radialement vers l'extérieur sont respectivement disposées sur des portions d'extrémité des premier et deuxième noyaux de détection (32 et 33) se faisant face l'une à l'autre ; et
l'élément de détection magnétique (5) est disposé entre les portions protubérantes (32b et 33b, 45 et 46).

12. Détecteur de position magnétique selon la revendication 11, dans lequel les portions protubérantes (45 et 46) sont configurées en tant que parties distinctes des premier et deuxième noyaux de détection (32 et 33) et sont montées sur les premier et deuxième noyaux de détection (32 et 33).

13. Détecteur de position magnétique selon la revendication 9, dans lequel :
un entrefer de régulation de fluctuation (g3) qui supprime des fluctuations de densité de flux magnétique en raison d'un déplacement de l'unité magnétique (36) dans un sens à destination ou à l'écart des premier et deuxième noyaux de détection (32 et 33) est disposé entre les premier et deuxième noyaux magnétiques (38 et 39) et les premier et deuxième noyaux de détection (32 et 33) et entre l'aimant (40) et les premier et deuxième noyaux de détection (32 et 33) ;
l'aimant (40) est divisé circonférentiellement en une pluralité de segments d'aimant (40a, 40b, 40c) ;
au moins un entrefer de segments d'aimant (g6, g7, g8) est disposé entre les segments d'aimant (40a, 40b, 40c) ; et
une forme en coupe transversale des premier et deuxième noyaux de détection (32 et 33) est modifiée de sorte qu'une taille de l'entrefer de régulation de fluctuation (g3) soit inférieure à une position à proximité de l'entrefer de segments d'aimant (g6, g7, g8) qu'à d'autres positions.

14. Détecteur de position magnétique selon la revendication 13, dans lequel la forme en coupe transversale des premier et deuxième noyaux de détection (32 et 33) est polygonale.

15. Détecteur de position magnétique selon la revendication 9, dans lequel :
l'aimant (40) est divisé circonférentiellement en une pluralité de segments d'aimant (40a, 40b, 40c) ;
au moins un entrefer de segments d'aimant (g6, g7, g8) est disposé entre les segments d'aimant (40a, 40b, 40c) ; et
une épaisseur de paroi des segments d'aimant (40a, 40b, 40c) est supérieure à proximité de l'entrefer de segments d'aimant (g6, g7, g8) que dans d'autres portions.

16. Détecteur de position magnétique selon la revendication 9, dans lequel :
un entrefer de régulation de fluctuation (g3) qui supprime des fluctuations de densité de flux magnétique en raison d'un déplacement de l'unité magnétique (36) dans un sens à destination ou à l'écart des premier et deuxième noyaux de détection (32 et 33) est disposé entre les premier et deuxième noyaux magnétiques (38 et 39) et les premier et deuxième noyaux de détection (32 et 33) et entre l'aimant (40) et les premier et deuxième noyaux de détection (32 et 33) ;
les premier et deuxième noyaux magnétiques (38 et 39) ont respectivement des portions de bride (38a et 39a) qui font face à une surface circonférentielle intérieure des premier et deuxième noyaux de détection (32 et 33) ;
l'aimant (40) est divisé circonférentiellement en une pluralité de segments d'aimant (40a, 40b, 40c) ;
au moins un entrefer de segments d'aimant (g6, g7, g8) est disposé entre les segments d'aimant (40a, 40b, 40c) ; et
une forme circonférentielle extérieure des portions de bride (38a et 39a) est modifiée de sorte qu'une distance entre les portions de bride (38a et 39b) et la surface circonférentielle intérieure des premier et deuxième noyaux de détection (32 et 33) soit réduite à proximité de l'entrefer de segments d'aimant (g6, g7, g8) .
